# EUROPEAN PATENT SPECIFICATION

(11) **EP 0 350 771 B1**
(45) Date of publication and mention of the grant of the patent: **12.10.1994**
(21) Application number: 89112200.4
(22) Date of filing: 04.07.1989
(51) Int. Cl.: H01L 29/788, H01L 27/115, G11C 17/00

(54) **Electrically erasable, electrically programmable read-only memory cell with a self-aligned tunnel window**
Elektrisch löschbare und elektrisch programmierbare Nurlesespeicherzelle mit einem selbstjustierten Tunneleffekt-Fenster
Cellule de mémoire morte effaçable et programmable électriquement ayant une fenêtre pour effet tunnel auto-alignée

(30) Priority: 15.07.1988 US 219529
(43) Date of publication of application: 17.01.1990
(73) Proprietor: TEXAS INSTRUMENTS INCORPORATED, Dallas Texas 75265 (US)
(72) Inventor: Gill, Manzur, Rosharon Texas 77583 (US); Lin, Sung Wei, Houston Texas 77083 (US)
(74) Representative: Leiser, Gottfried, Dipl.-Ing.

(56) References cited:
- EP-A- 0 105 802
- EP-A- 0 308 316
- US-A- 4 466 174
- WO A 85/01146

## Description

### RELATED CASES

This application discloses subject matter also disclosed in co-pending U.S. Patent Applications No. 07/(interim designation TI-12792A) and No. 07/(interim designation TI-12793A), filed herewith and also assigned to Texas Instruments Incorporated. The foregoing applications are hereby incorporated herein by reference.

### BACKGROUND OF THE INVENTION

This invention relates to semiconductor memory devices, and more particularly to an electrically-erasable, electrically-programmable ROM (read-only-memory) of the floating-gate type, and to a method for making such a device.

EPROMs, or electrically-programmable ROMs, are field-effect devices with a floating-gate structure. An EPROM floating gate is programmed by applying proper voltages to the source, drain and control gate of each cell, causing high current through the source-drain path and charging of the floating gate by hot electrons. The EPROM type of device is erased by ultraviolet light, which requires a device package having a quartz window above the semiconductor chip. Packages of this type are expensive in comparison with the plastic packages ordinarily used for other memory devices such as DRAMs (dynamic-random-access-memories). For this reason, EPROMs are generally more expensive than plastic-packaged devices. EPROM devices of this type, and methods of manufacture, are disclosed in U.S. Patents 3,984,822; 4,142,926; 4,258,466; 4,376,947; 4,326,331; 4,313,362; or 4,373,248; for example. Of particular interest to this invention is U.S. Patent No. 4,750,024, issued June 7, 1988 and filed Feb. 18, 1986 by John F. Schreck and assigned to Texas Instruments Incorporated, where an EPROM is shown made by a method similar to that of Patent 4,258,466; but with an offset floating gate.

EEPROMs, or electrically-erasable, electrically-programmable ROMs, have been manufactured by various processes, usually requiring a much larger cell size than standard EPROMs, and requiring more complex manufacturing processes. EEPROMs can be mounted in opaque plastic packages that reduce the packaging cost. Nevertheless, EEPROMs have been more expensive on a per-bit basis, in comparison with EPROMs, due to larger cell size and to more complex manufacturing processes.

Flash EEPROMs have the advantage of smaller cell size in comparison with standard EEPROMs because the cells are not erased individually. Instead, the array of cells is erased in bulk.

Currently available flash EEPROMs require two power supplies, one for programming and erasing and another for reading. Typically, a 12-volt power supply is used for programming and erasing and a 5-volt power supply is used during read operations. It is desirable, however, to employ a single relatively low-voltage supply for all of the programming, erasing and reading operations.

The EEPROMs disclosed in co-pending EP-A-0 326 877 and EP-A-0 326 879 provide a greatly improved structure and method for making cells having reduced size and ease of manufacture, resulting in a device requiring one relatively low-voltage (perhaps +5v) power supply to the chip. Nevertheless, in some situations improvement in the break-down voltage at the source-to-substrate interface beneath the edge of the source region, as explained below, is believed to be possible in such devices.

A further prior art EEPROM is known from EP-A-0 105 802.

It is the principal object of the invention to provide an EEPROM in which the tunnel is self-aligned so that manufacture is facilitated and reliability is enhanced. Further, it is an object to provide an EEPROM having reduced cell size and having improved coupling between control gate and floating gate. Other objects include provision of a cell resistant to bitline stress, which is the deprogramming of a programmed cell during write operations, and include improved field-plate breakdown voltage. Another object of this invention is to provide an electrically programmable memory, or an electrically-erasable and electrically-programmable memory, which can be packaged in a less expensive opaque plastic package. Another object is to provide an improved method of making an electrically erasable memory, including the use of a method for forming a tunnel window having dimensions smaller than the minimum spacing allowed by usual design rules, allowing the cell size to be smaller and facilitating scaling. It is also an object to provide a non-volatile memory that uses a single low-voltage external supply for both programming and erasing, allowing the memory device to be compatible with on-board or in-circuit programming where systems have a single external power supply. An additional object is to provide an electrically-programmable memory that does not require high current for both programming and erasing.

### SUMMARY OF THE INVENTION

In accordance with one embodiment of the invention, an electrically-erasable PROM or an EEPROM is constructed using an enhancement transistor merged with a floating-gate transistor. The floating-gate transistor has a small self-aligned tunnel window positioned above the source away from the channel region. The EEPROM device has a contact-free cell layout, enhancing the ease of manufacture and reducing cell size. The device has bitlines (source/drain regions) that are buried beneath relatively thick silicon oxide, allowing a favorable ratio of control gate to floating gate capacitance. Programming and erasing are accomplished using the tunnel window area on the opposite side of the bitline from the channel and drain. The tunnel window has a thinner dielectric than the remainder of the floating gate, allowing Fowler-Nordheim tunneling. By using dedicated drain and ground lines, rather than a virtual-ground circuit layout, and by using thick oxide for isolation between the bitlines of adjacent cells, the floating gate can extend onto adjacent bitlines and isolation areas, resulting in a favorable coupling ratio.

### BRIEF DESCRIPTION OF THE DRAWINGS

The novel features believed characteristic of the invention are set forth in the appended claims. The invention itself, however, as well as other objects and advantages thereof, will be best understood by reference to the following description of particular embodiments thereof, when read in conjunction with the accompanying drawings, in which:
Figure 1 is a plan view of a small part of a semiconductor chip having memory cells according to one embodiment;
Figures 2a-2e are elevation views in section of the semiconductor device of Figure 1, taken along the lines a-a, b-b, c-c, d-d, and e-e of Figure 1;
Figure 3 is an electrical schematic diagram of the cells of Figures 1 and 2a-2e; and
Figures 4a-4d are elevation views in section, corresponding to Figure 2a, of the device of Figures 1 and 2a-2e, at successive stages in the manufacture thereof.

### DETAILED DESCRIPTION OF SPECIFIC EMBODIMENT

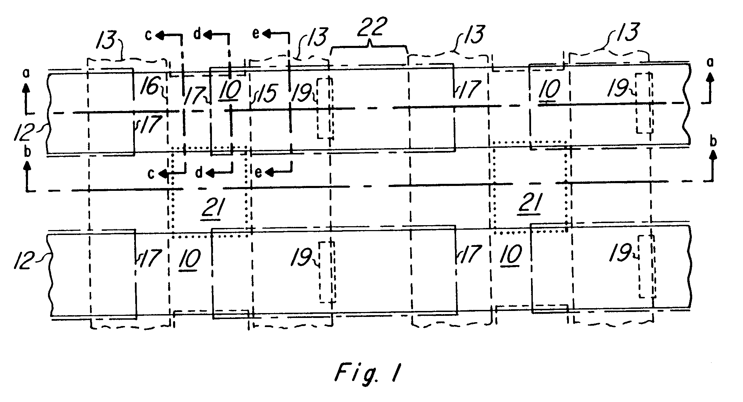

Referring now to Figures 1, 2a-2e and 3, an array of electrically-erasable, electrically-programmable memory cells 10 is shown formed in a face of a silicon substrate 11. Only a very small part of the substrate is shown in the Figures, it being understood that these cells are part of an array of a very large number of such cells. A number of wordlines/control gates 12 are formed by second-level polycrystalline silicon (polysilicon) strips extending along the face of the substrate 11, and bitlines 13 are formed beneath thick thermal silicon oxide layers 14 in the face. These buried bitlines 13 create the source region 15 and the drain region 16 for each of the cells 10. A floating gate 17 for each cell is formed by a first-level polysilicon layer extending across about half of a cell and across one bitline and extending over onto another adjacent bitline 13. Two "horizontal", or X-direction, edges of the floating gate 17 for a cell are aligned with the edges of a wordline 12.

According to the invention, a tunnel area 19 for programming and erasure is formed adjacent the source 15 of each cell, on the opposite side of the source from the drain 16 and the channel, compared to the cells shown in the above-identified co-pending EP-A-0 326 877 and EP-A-0 326 879, in which the tunnel window is near the source in the channel region between the source 15 and drain 16. The silicon oxide at this tunnel window 19 is thinner, about 100A (10A = 1nm), compared to the dielectric coating 20 of about 350A at the channel or compared to about 500A for the series enhancement transistor. Programming and erasing can be performed at relatively low externally-applied voltages using this structure. The coupling between layer 12 and layer 17, compared to coupling between floating gate 17 and source 15 or substrate 11, is more favorable because the floating gate extends out across the bitlines 13 and an isolating area 22. Therefore, a larger fraction of the programming/erasing voltages applied between control gate 12 and source 15 will appear between floating gate 17 and source 15. The cell 10 is referred to as "contact-free" in that no source/drain contact is needed in the vicinity of cell itself.

An area 21 is used to isolate cells from one another in the Y-direction. This area 21 may be a thick field oxide area similar to the area 21 of the above-identified co-pending U.S. Patent Application No. 07/(interim designation TI-12792A), or area 21 may be implanted with P-type impurity as disclosed in the above-identified co-pending EP-A-0 326 877 and EP-A-0 326 879. Strips 22 of LOCOS thick field oxide separate bitlines 13 between cells in the X-direction. Note that the array of cells is not of the "virtual-ground-circuit" type; that is, there are two bitlines 13 or column lines (one for source, one for drain) for each column (Y-direction) of cells, one bitline being a dedicated ground, and one being the data input/output and sense line.

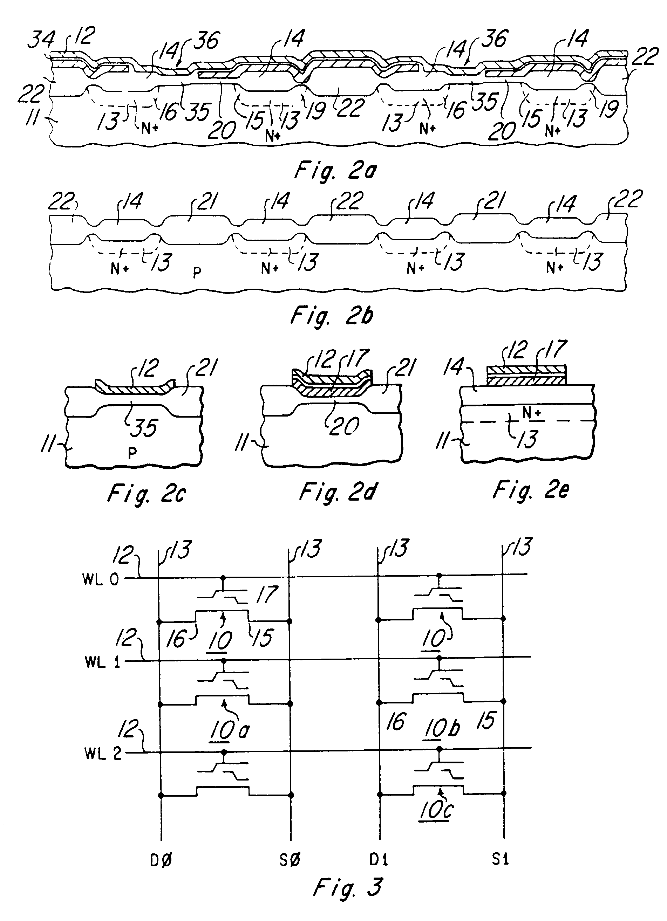

The EEPROM cells of Figures 1, 2a-2e and 3 are programmed with a voltage Vpp applied to the selected wordline 12 of about +16 to +18v with respect to the source 15 of the selected cell 10. The source 15 of the selected cell 10 is at ground or other reference voltage. For example, in Figure 3, if the cell 10a is selected to be programmed, then the selected wordline 12 labelled WL1 is brought to +Vpp and the selected source labelled S0 is grounded. The voltage +Vpp can be internally generated with charge pumps on the chip, with the externally-applied supply voltage having a relatively small positive potential, perhaps +5v. The selected drain 16 (labelled D0 in this example) is allowed to float under these programming conditions so there is little or no current through the source-drain path. The Fowler-Nordheim tunneling across the tunnel oxide 19(with thickness of about 100A) charges the floating gate 17 of the selected cell 10a, resulting in a shift in threshold voltage Vt of perhaps 3-6 volts after a programming pulse approximately 10 milliseconds in length.

A selected cell is erased by applying a voltage Vee (internally-generated) of perhaps -10v on the selected wordline/control gate 12 and a voltage of about +5v on the source 15 or bitline 13. The drain 16 (the other bitline 13) is allowed to float. During erasure tunneling, electrons flow from the floating gate 17 to the source 15 because the control gate 12 is negative with respect to the source 15.

Alternatively, the selected cell may be erased by applying an internally generated voltage of approximately 10-15 volts positive to the selected source 15, allowing the selected drain 16 to float, and connecting the selected control gate 12 to reference potential or 0 volts. Use of this method for erasure avoids the need for the negative voltage supply used in the procedure described above.

When a "flash erase" is performed (all cells 10 are erased) at the same time), all of the drains 16 in the array are allowed to float, all of the sources 15 are at potential Vdd, and all of the wordlines/control gates 12 are at potential -Vee.

To prevent a write-disturb condition during the programming example (cell 10a being programmed), all of the sources 15 of non-selected cells, such as cell 10b, on the same wordline WL1 of Figure 3 are held at a voltage Vbl, which is in the approximate range of 5-7 volts positive. The drains 16 of non-selected cells such as 10b are allowed to float, preventing source-drain currents from flowing. The voltage Vbl applied to the sources 15 prevents the electric fields across the tunnel oxides 19 of the cells, including example cell 10b, from becoming large enough to charge the floating gates 17.

Another condition to be avoided is the "bitline stress", or deprogramming, associated with a high electric field across the tunnel oxide of a programmed cell when the source of the cell is at a potential near Vbl. To prevent this bitline stress condition, the non-selected wordlines/control gates WL0 and WL2 of Figure 3 are held at a voltage in the approximate range of 5-10 volts positive, thereby reducing the electric field across the tunnel oxide 19 of each non-selected programmed cell. A programmed cell such as 10c has a potential of about -2 to -4 volts on its floating gate, so when the voltage Vbl on the source S1 of such a cell 10c is in the range of 5-7 volts positive, the field across the tunnel oxide could tend to deprogram the cell, but with voltage in the range of 5-10 volts positive on the wordline WL2, the electric field is reduced. The voltage on the wordline/control gate is not so great, however, as to cause a change in threshold voltage Vt in a cell having no charge on its floating gate.

The cells described above can be read at low voltage. For example, a row of cells can be read by placing +3v on the selected wordline/control gate, zero volts on all of the other wordlines/control gates, zero volts on all of the sources, and +1.5v on all of the drains. In this condition, the source-drain path of a cell will be conductive with the cell in an erased state (a cell with zero charge on its floating gate), i.e., storing a logic one. A programmed cell (programmed to the high-voltage-threshold state, with negative charge on the floating gate) will not conduct, i.e., storing a logic zero.

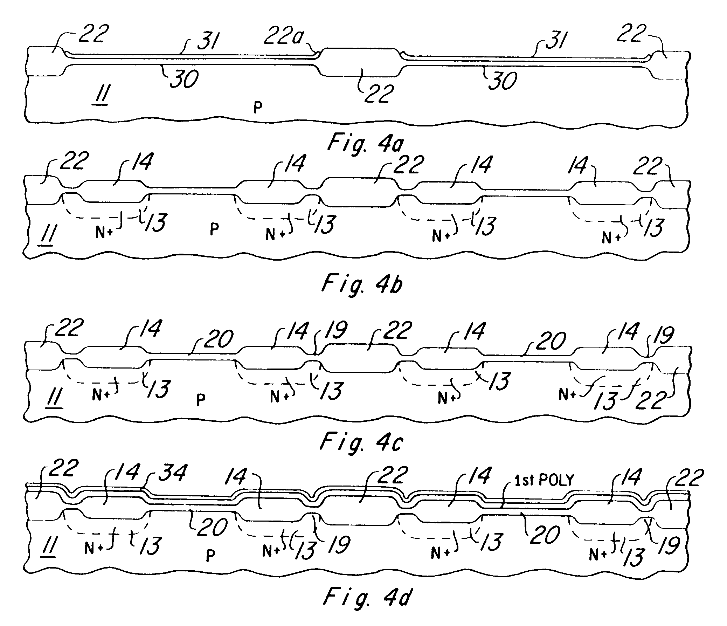

A method of making the device of Figures 1 and 2a-2e will be described in reference to Figures 4a-4d. The starting material is a slice of P-type silicon of which the substrate 11 is only a very small portion. The slice is perhaps 6 inches in diameter, while the portion shown in Figure 1 is only a few microns wide. A number of process steps would be performed to create transistors peripheral to the array, and these will not be discussed here. For example, the memory device may be of the complementary field-effect type having N-wells and P-wells formed in the substrate as part of a prior process to create peripheral transistors. The first step related to the cell array of the invention is applying oxide and silicon nitride coatings 30 and 31 as seen in Figure 4a, and patterning these coatings using photoresist to leave nitride over what will be the channel regions, tunnel areas, sources, drains, and bitlines 13, while exposing the areas where the thick field oxide 22 (and 21, if oxide isolation is used) is to be formed. A boron implant at about 8x10¹² cm⁻² dosage is performed to create a P+ channel stop beneath the field oxide 22 (and 21, if applicable). Then the field oxide is grown to a thickness of about 9000A by exposing to steam at about 900°C for several hours. The thermal oxide grows beneath the edges of the nitride 31, creating a "bird's beak" 22a instead of a sharp transition.

Turning now to Figure 4b, the nitride 31 is removed and, in the area where the bitlines 13 are to be formed, an arsenic implant is performed at a dosage of about 6x10¹⁵ cm⁻² at 136 KeV, using photoresist as an implant mask, to create the source/drain regions and bitlines. Next, another thermal oxide 14 is grown on the face to a thickness of about 2500 to 3500A over the N+ buried bitlines, during which time a thermal oxide of about 300A will grow over the channel areas (due to the differential oxidation occurring when heavily-doped and lightly-doped silicon areas are exposed to oxidation at the same time), to create the oxide layers 14 above the source/drain regions and bitlines 13. This oxidation is in steam at about 800 to 900°C. At the transition areas 18 where the bird's beak 22a has been formed, the edge of the originally-formed thermal oxide has masked the arsenic implant so the concentration is lower and so the oxide growth in that area is less than that of the oxide 14 or the oxide 22.

Referring to Figure 4c, a window 19 is opened in the oxide in the transition area 18. This is done using photoresist as a mask, and etching through the oxide of transition area 18 to the bare silicon, then regrowing a thinner oxide for the tunnel window 19. During oxidation of tunnel window 19, gate oxide 20 will grow to approximately 350A. Optionally, a light phosphorus implant in the tunnel window 19 can be used for enhanced field plate breakdown voltage.

Because of the curved surface of transition area 18, the width of tunnel window 19 may be controlled by varying the length of time for the etch through transition area 18.

A first polysilicon layer, doped N+, is now applied to the face of the silicon slice, and a coating 34 of oxide, or oxide-nitride-oxide, is applied to separate the two polysilicon levels. The first-level polysilicon is defined using photoresist to leave elongated strips in the Y-direction, parts of which will become the floating gates 17. An oxidation, performed after the first-level polysilicon is defined, covers the edges of first-level polysilicon, and also creates the gate oxides 35 for the series enhancement transistors 36. A second polysilicon layer is deposited, doped N+, and patterned using photoresist to create the wordlines/control gates 12. At the same time as the wordlines/control gates 12 are defined, the edges of the first-level polysilicon are etched, so that the elongated X-direction edges of the floating gates are self-aligned with the edges of the control gates. It should be noted that the Figures are not drawn to scale and that, in particular, the thickness of the first and second polysilicon layers are generally much greater than the thickness of oxide layers 19, 20 and 35.

If junction isolation is to be used for the isolating regions 21, a self-aligned ion implant step is performed, using the stacked polysilicon-1 and polysilicon-2 layers of wordlines/control gates 12 and floating gates 17 as a mask to create the isolating regions 21. For this purpose, boron is implanted at a dosage of about 10¹² cm⁻², at about 70 KeV. After annealing and oxidation, this implant produces P+ regions under regions 21 very much like channel stop implants beneath field oxide.

One advantage of the placement of the tunnel window on the opposite side of the source from the drain as described above is that the alignment of the masks in manufacture is considerably less critical, compared to the methods disclosed in the above-identified applications. In addition, an important advantage is that the field-plate breakdown voltage of the junction between the buried N+ region and the substrate is enhanced due to the fact that on both sides of the N+ to P junction the overlying oxide has greater thickness than the 100A tunnel oxide. Additionally, the overall cell size can be reduced because the alignments for the tunnel need not be considered. The tunnel itself can have a width smaller than the minimum spacing allowed by usual design rules. Also the cell is capable of "scaling" in a bar shrink or re-design.

## Claims

1. An electrically-erasable, electrically-programmable, floating-gate memory cell (10), comprising:
a source region (15) and a drain region (16) formed in a face of a semiconductor body (11), each of said regions (15,16) being heavily-doped and of conductivity-type opposite that of underlying material of said body (11), each of said regions (15,16) being buried under a layer (14) of silicon oxide on said face, said source region (15) being spaced from said drain region (16) on said face by a channel area,
a floating gate (17) over at least a part of said channel area and extending onto said silicon oxide layer (14) over the source region (15), the floating gate (17) being separated from the channel area of said face by a gate insulator (20),
a tunnel area (19) adjacent said source region (15) but on the opposite side of said source region (15) from said channel area, said floating gate (17) also extending over said tunnel area (19) and being separated from said tunnel area (19) by a tunnel insulator, the thickness of said tunnel insulator at said tunnel area being much less than the thickness of said gate insulator (20) at the channel area, and
a control gate (12) extending along said face over said floating gate (17) and over said source and drain regions (15,16), said control gate (12) being separated from said floating gate (17) by an insulator coating (34)
characterized in that said silicon oxide layer (14) is much thicker than said gate insulator (20) at said channel area.

2. A memory cell (10) according to claim 1 wherein said semiconductor body (11) is silicon, and said source and drain regions (15,16) are N+ type.

3. A memory cell (10) according to claim 1 wherein said floating gate (17) and said control gate (12) are polycrystalline silicon layers.

4. A memory cell (10) according to claim 1 wherein said control gate (12) is part of an elongated wordline (12) extending along said face, and wherein said source and drain regions (15, 16) are parts of elongated bitlines (11) extending along said face perpendicular to said wordline.

5. A memory cell (10) according to claim 1 wherein said control gate (12) is aligned with edges of said floating gate (17).

6. A memory cell (10) according to claim 1 wherein there is no contact formed between said source or drain regions (15,16) and overlying conductor layers and in the vicinity of said cell (10).

7. A memory cell (10) according to claim 1 wherein the width of said tunnel area (19) is adjustable by oxide etch.

8. A memory cell (10) according to claim 1 wherein said tunnel area (19) is self-aligned.

9. A memory cell (10) according to claim 1 wherein the sources (15) of non-selected cells (10) are held at a positive voltage during programming.

10. A memory cell (10) according to claim 1 wherein the wordlines (12) of non-selected cells (10) are held at a positive voltage during programming.

11. A method for making an erasable electrically-programmable, floating-gate memory cell array including column lines in a face of a semiconductor body and row lines on said face, comprising the steps of:
applying a layer of an oxidation-resistant material to said face of a semiconductor body, and patterning said layer so source and drain areas of said face and channel areas of said face are covered, and so tunnel areas of said face located above said source areas on sides of said source areas opposite from said channel areas are covered,
growing an oxide coating on said face to create a first field oxide where said face is not covered by said oxidation-resistant material,
selectively implanting an impurity into said face to create source and drain regions along said areas of said column lines,
growing a second field oxide on said face to form thick thermal oxide coatings over said source and drain regions,
growing a gate oxide coating on said face over said channel area and over said tunnel area to a first thickness which is much less than said first and second field oxides, then opening a window in said gate oxide coating over said tunnel area and regrowing gate oxide in said window to a second thickness significantly thinner than said first thickness to thereby provide a tunnel window, the tunnel window being self-aligned with said first field oxide on one side and said second field oxide on the other,
applying a first conductive layer on said face and patterning said first conductive layer to leave a floating gate over said channel area and partially overlapping said source region and said first field oxide, and
applying a second conductive layer on said face overlying and insulated from said first conductive layer to create a control gate above said floating gate.

12. A method according to claim 11 wherein said semiconductor body is P-type silicon and said impurity is N-type silicon.

13. A method according to claim 11 wherein said first and second layers are polycrystalline silicon.

14. A method according to claim 11 wherein said first thickness is greater than said second thickness, and the thickness of said first and second field oxide is much greater than said first thickness.

15. A method according to claim 11 wherein a light phosphorus implant is performed prior to regrowing said gate oxide in said tunnel window to said second thickness.

## Patentansprüche

1. Elektrisch löschbare, elektrisch programmierbare Speicherzelle (10) mit schwimmendem Gate, enthaltend:
eine Source-Zone (15) und eine Drain-Zone (16) in einer Fläche eines Halbleiterkörpers (11), wobei jede dieser Zonen (15, 16) stark dotiert ist und einen dem Leitungstyp des darunterliegenden Materials des Körpers (11) entgegengesetzten Leitungstyp hat, wobei jeder der Zonen (15, 16) unter einer Schicht (14) aus Siliciumoxid auf der Fläche begraben ist, wobei die Source-Zone (15) durch einen Kanalbereich von der Drain-Zone (16) beabstandet ist,
ein schwimmendes Gate (17) über wenigstens einen Teil des Kanalbereichs, das sich über der Source-Zone (15) auf die Siliciumoxidschicht (14) erstreckt, wobei das schwimmende Gate (17) durch einen Gate-Isolator (20) von dem Kanalbereich der Fläche getrennt ist,
einen Tunnelbereich (19), der an die Source-Zone (15) angrenzt, jedoch bezüglich des Kanalbereichs auf der entgegengesetzten Seite der Source-Zone (15) liegt, wobei sich das schwimmende Gate (17) auch über den Tunnelbereich (19) erstreckt und von diesem Tunnelbereich (19) durch einen Tunnel-Isolator getrennt ist, dessen Dicke bei dem Tunnelbereich wesentlich geringer als die Dicke des Gate-Isolators (20) bei dem Kanalbereich ist, und
ein Steuer-Gate (12), das sich längs der Fläche über dem schwimmenden Gate (17) und über den Source- und Drain-Zonen (15, 16) erstreckt, wobei das Steuer-Gate (12) durch einen Isolatorüberzug (34) von dem schwimmenden Gate (17) getrennt ist,
dadurch gekennzeichnet, daß die Siliciumoxidschicht (14) bei dem Kanalbereich wesentlich dicker als der Gate-Isolator (20) ist.

2. Speicherzelle (10) nach Anspruch 1, bei welcher der Halbleiterkörper (11) aus Silicium besteht und die Source- und Drain-Zonen (15, 16) vom (N+)-Typ sind.

3. Speicherzelle (10) nach Anspruch 1, bei welcher das schwimmende Gate (17) und das Steuer-Gate (12) polykristalline Siliciumschichten sind.

4. Speicherzelle (10) nach Anspruch 1, bei welcher das Steuer-Gate (12) ein Teil einer verlängerten Wortleitung (12) ist, die sich längs der Fläche erstreckt, und bei welcher die Source- und Drain-Zonen (15, 16) Teile verlängerter Bitleitungen (11) sind, die sich längs der Fläche senkrecht zu der Wortleitung erstrecken.

5. Speicherzelle (10) nach Anspruch 1, bei welcher das Steuer-Gate (12) in einer Linie mit den Rändern des schwimmenden Gates (17) verläuft.

6. Speicherzelle (10) nach Anspruch 1, bei welcher zwischen den Source- oder Drain-Zonen (15, 16) und darüberliegenden Kontaktschichten in der Nähe der Zelle (10) kein Kontakt gebildet ist.

7. Speicherzelle (10) nach Anspruch 1, bei welcher der Tunnelbereich (19) durch Oxidätzung einstellbar ist.

8. Speicherzelle (10) nach Anspruch 1, bei welcher der Tunnelbereich (19) selbstjustiert ist.

9. Speicherzelle (10) nach Anspruch 1, bei welcher die Source-Zonen (15) nicht ausgewählter Zellen (10) während der Programmierung auf einer positiven Spannung gehalten sind.

10. Speicherzelle (10) nach Anspruch 1, bei welcher die Wortleitungen (12) nicht ausgewählter Zellen (10) während der Programmierung auf einer positiven Spannung gehalten sind.

11. Verfahren zum Herstellen einer löschbaren elektrisch programmierbaren Matrix aus Speicherzellen mit schwimmendem Gate mit Spaltenleitungen in einer Fläche eines Halbleiterkörpers und Zeilenleitungen auf der Fläche, enthaltend die Schritte:
Anbringen einer Schicht aus einem oxidationsbeständigen Material auf der Fläche eines Halbleiterkörpers und Strukturieren dieser Schicht so, daß Source- und Drain-Bereiche der Fläche sowie Kanalbereiche der Fläche bedeckt werden und Tunnelbereiche der Fläche, die über den Source-Bereichen auf seiten dieser Source-Bereiche gegenüber den Kanalbereichen liegen, bedeckt werden,
Aufwachsen eines Oxidüberzugs auf der Fläche zur Erzeugung eines ersten Feldoxids, wo die Fläche nicht mit dem oxidationsbeständigen Material bedeckt ist,
selektives Implantieren eines Störstoffs in die Fläche zur Erzeugung von Source- und Drain-Zonen längs der Bereiche der Spaltenleitungen,
Aufwachsen eines zweiten Feldoxids auf der Fläche zur Bildung dicker thermischer Oxidüberzüge über den Source- und Drain-Zonen,
Aufwachsen eines Gateoxidüberzugs auf der Fläche über dem Kanalbereich und über dem Tunnelbereich bis zu einer ersten Dicke, die viel geringer als das erste und das zweite Feldoxid ist, dann Öffnen eines Fensters in dem Gateoxidüberzug über dem Tunnelbereich und erneutes Aufwachsen von Gateoxid in dem Fenster bis zu einer zweiten Dicke, die beträchtlich dünner als die erste Dicke ist, damit dadurch ein Tunnelfenster geschaffen wird, wobei das Tunnelfenster selbstjustiert ist und das erste Feldoxid auf der einen Seite und das zweite Feldoxid auf der anderen Seite liegt,
Aufbringen einer ersten leitenden Schicht auf der Fläche und Strukturieren der ersten leitenden Schicht in der Weise, daß über dem Kanalbereich und in teilweiser Überlappung der Source-Zone und des ersten Feldoxids ein schwimmendes Gate zurückbleibt, und
Aufbringen einer zweiten leitenden Schicht auf der Fläche über der ersten leitenden Schicht und davon isoliert, damit ein Steuer-Gate über dem schwimmenden Gate entsteht.

12. Verfahren nach Anspruch 11, bei welchem der Halbleiterkörper aus Silicium vom P-Typ besteht und der Störstoff Silicium vom N-Typ ist.

13. Verfahren nach Anspruch 11, bei welchem die erste und die zweite Schicht aus polykristallinem Silicium bestehen.

14. Verfahren nach Anspruch 11, bei welchem die erste Dicke größer als die zweite Dicke ist und die Dicke des ersten und des zweiten Feldoxids viel größer als die erste Dicke ist.

15. Verfahren nach Anspruch 11, bei welchem vor dem erneuten Aufwachsen des Gateoxids in dem Tunnelfenster auf die zweite Dicke eine leichte Phosphorimplantierung durchgeführt wird.

## Revendications

1. Cellule de mémoire (10) à grille flottante, effaçable et programmable électriquement comprenant :
- une région de source (15) et une région de drain (16) formées dans une face d'un corps semi-conducteur (11), chacune desdites régions (15,16) étant fortement dopée et d'un type de conductivité opposé à celui d'un matériau sousjacent dudit corps (11), chacune desdites régions (15,16) étant enterrées sous une couche (14) d'oxyde de silicium sur ladite face, ladite région de source (15) étant espacée de ladite région de drain (16) sur ladite face par une zone de canal,
- une grille flottante (17) sur au moins une partie de ladite zone de canal et s'étendant sur ladite couche d'oxyde de silicium (14) au-dessus de la région de source (15), la grille flottante (17) étant séparée de la zone de canal de ladite face par un isolant de grille (20),
- une zone de tunnel (19) adjacente à ladite région de source (15) mais du côté opposé de ladite région de source (15) par rapport à ladite zone de canal, ladite grille flottante (17) s'étendant également au-dessus de ladite zone de tunnel (19) et étant séparée de ladite zone de tunnel (19) par un isolant de tunnel, l'épaisseur dudit isolant de tunnel à ladite zone de tunnel étant beaucoup moins importante que l'épaisseur dudit isolant de grille (20) à la zone de canal, et
- une grille de commande (12) s'étendant le long de ladite face sur ladite grille flottante (17) et au-dessus desdites régions de drain et de source (15,16), ladite grille de commande (12) étant séparée de la grille flottante (17) par un revêtement isolant (34),
caractérisée en ce que ladite couche d'oxyde de silicium (14) est plus épaisse que ledit isolant de grille (20) à ladite zone de canal.

2. Cellule de mémoire (10) selon la revendication 1, dans laquelle le corps semi-conducteur (11) est en silicium et lesdites régions de drain et de source (15,16) sont de type N+.

3. Cellule de mémoire (10) selon la revendication 1, dans laquelle ladite grille flottante (17) et ladite grille de commande (12) sont formées par des couches de silicium polycristallin.

4. Cellule de mémoire (10) selon la revendication 1, dans laquelle ladite grille de commande (12) est une partie d'une ligne de mot allongée (12) s'étendant le long de ladite face et dans laquelle lesdites régions de drain et de source (15,16) sont des parties de lignes de bit allongées (11) s'étendant le long de ladite face perpendiculairement à ladite ligne de mot.

5. Cellule de mémoire (10) selon la revendication 1, dans laquelle la grille de commande (12) est alignée avec des bords de ladite grille flottante (17).

6. Cellule de mémoire (10) selon la revendication 1, dans laquelle il n'y a pas de contact formé entre lesdites régions de drain et de source (15,16) et des couches conductrices de recouvrement à proximité de ladite cellule (10).

7. Cellule de mémoire (10) selon la revendication 1, dans laquelle la largeur de ladite zone de tunnel (19) est réglable par attaque oxyde.

8. Cellule de mémoire (10) selon la revendication 1, dans laquelle ladite zone de tunnel (19) est auto-alignée.

9. Cellule de mémoire (10) selon la revendication 1, dans laquelle les sources (15) de cellules non-sélectionnées (10) sont maintenues à une tension positive durant une programmation.

10. Cellule de mémoire (10) selon la revendication 1, dans laquelle les lignes de mot (12) de cellules non-sélectionnées (10) sont maintenues à une tension positive durant une programmation.

11. Procédé pour réaliser un réseau de cellules de mémoires à grille flottante, effaçables et programmables électriquement, comprenant des lignes de colonnes dans une face d'un corps semi-conducteur et des lignes de rangées sur ladite face, comportant les étapes de :
- application d'une couche d'un matériau résistant à l'oxydation à ladite face d'un corps semi-conducteur et configuration de ladite couche de manière que des zones de drain et de source de ladite face et des zones de canal de ladite face soient recouvertes et de manière que des zones de tunnel de ladite face situées au-dessus desdites zones de source sur des côtés desdites zones de source opposées auxdites zones de canal, soient recouvertes,
- croissance d'un revêtement d'oxyde sur ladite face pour créer un premier oxyde de champ où ladite face n'est pas recouverte par ledit matériau résistant à l'oxydation,
- implantation sélective d'une impureté dans ladite face pour créer des régions de source et de drain, le long desdites zones desdites lignes de colonnes,
- croissance d'un second oxyde de champ sur ladite face pour former des revêtements d'oxyde thermique épais sur lesdites régions de source et de drain,
- croissance d'un revêtement d'oxyde de grille sur ladite face au-dessus de ladite zone de canal et au-dessus de ladite zone de tunnel à une première épaisseur qui est beaucoup plus faible que lesdits premier et second oxydes de champ, puis ouverture d'une fenêtre dans ledit revêtement d'oxyde de grille sur ladite zone de tunnel et nouvelle croissance d'un oxyde de grille dans ladite fenêtre à une seconde épaisseur sensiblement plus faible que ladite première épaisseur pour fournir ainsi une fenêtre de tunnel, la fenêtre de tunnel étant auto-alignée avec ledit premier oxyde de champ sur un côté et ledit second oxyde de champ sur l'autre,
- application d'une première couche conductrice sur ladite face et configuration de ladite première couche conductrice pour laisser une grille flottante sur ladite zone de canal et chevauchement partiel de ladite région de source et dudit premier oxyde de champ, et
- application d'une seconde couche conductrice sur ladite face de recouvrement et isolée de ladite première couche conductrice pour créer une grille de commande au-dessus de ladite grille flottante.

12. Procédé selon la revendication 11, dans lequel ledit corps semi-conducteur est en silicium de type P et ladite impureté est en silicium de type N.

13. Procédé selon la revendication 11, dans lequel lesdites première et seconde couches sont en silicium polycristallin.

14. Procédé selon la revendication 11, dans lequel ladite première épaisseur est supérieure à ladite seconde épaisseur et l'épaisseur des premier et second oxydes de champ est beaucoup plus importante que ladite première épaisseur.

15. Procédé selon la revendication 11, dans lequel un implant de phosphore lumineux est réalisé avant la nouvelle croissance dudit oxyde de grille dans ladite fenêtre de tunnel à ladite seconde épaisseur.
